# EUROPEAN PATENT APPLICATION

(11) **EP 0 588 580 A2**
(43) Date of publication of application: **23.03.1994**
(21) Application number: 93307187.0
(22) Date of filing: 13.09.1993
(51) Int. Cl.: G03F 1/04, G03F 7/12, B41N 1/24, B41C 1/055

(54) **Method for making stencil master plates, and original paper sheet for stencil printing, stencil master plate sheet assembly, and stencil printing device suitable for use with the method**

(30) Priority: 14.09.1992 JP 244855/92
(71) Applicant: Riso Kagaku Corporation, Tokyo-to (JP)
(72) Inventor: Hasegawa, Takanori, c/o Riso Kagaku Corporation, Tokyo-to (JP); Harada, Atsushi, c/o Riso Kagaku Corporation, Tokyo-to (JP)
(74) Representative: Ben-Nathan, Laurence Albert

(57) **Abstract**

The method of the present invention allows a printing process based on the principle of superimposition to be carried out at high accuracy without requiring any difficult registration work. By using a single original paper sheet for stencil printing having a plurality of original images formed in different regions thereon at a predefined positional relationship, stencil master plates based on the original images are formed in different regions of a stencil master plate sheet assembly without changing the positional relationship between the stencil master plate sheet assembly and the original paper sheet.

## Description

### TECHNICAL FIELD

The present invention relates to a method for making stencil master plates, an original paper sheet for stencil printing and a stencil master plate sheet assembly suitable for use with the method, and in particular to a method for making stencil master plates, an original paper sheet for stencil printing and a stencil master plate sheet assembly suitable for use with the method which may be used for printing based on the principle of superimposition such as color printing.

### BACKGROUND OF THE INVENTION

Previously known is the simple manual stencil printing device suitable for printing postcards or the like in homes and offices which comprises a base including a printing paper table, and a pressure plate pivotally supported by the base at its one end, and detachably carrying a stencil master plate sheet on its surface facing the upper surface of the printing paper supporting table or the printing paper supporting surface.

By pressing down the pressure plate with a printing paper sheet supported on the printing paper supporting surface, and thereby pressing the stencil master plate supported by the pressure plate onto the printing paper against the printing paper supporting surface. Such a stencil printing device is disclosed for instance in Japanese utility model laid open (kokai) publication No. 62-196567.

As a stencil master plate sheet which can be used with such a stencil printing device, there is known the assembly type stencil master plate sheet in which a normal stencil master plate sheet is supported by a frame holder. An example of such a stencil master plate sheet is disclosed for instance in Japanese utility model laid open (kokai) publication No. 51-132007.

When multi-color printing such as full color printing is to be carried out by using such a stencil printing device, a stencil master plate for each of the color separated original images is individually prepared by using, for instance, a frame holder type stencil master plate sheet, and the stencil master plates thus prepared are sequentially positioned and mounted on the pressure plate. By thus repeating the printing process for each of the stencil master plates, a printing process based on superimposition can be carried out.

In such a superimposition printing process, the printing process for each of the stencil master plates must be carried out on a same position of the printing paper sheet. Otherwise, a mis-registration is produced in the printed images, and a satisfactory printing result cannot be obtained.

To carry out the printing process for each of the master plates on a same position of the printing paper sheet, it is necessary that each of the stencil master plate sheet assemblies must be positioned and mounted on an identical position in the stencil printing device, and the printing paper sheet must remain stationary on the printing paper supporting surface until the entire process of printing using all the stencil master plate sheet assemblies on the same printing paper sheet is completed. Furthermore, the stencil master plate formed in each of the stencil master plate sheet assemblies must be formed in an identical position.

Mounting each of the stencil master plate sheet assemblies on a same position of the stencil printing device can be accomplished by providing a conventional positioning structure in the pressure plate on which the stencil master plate sheet assemblies are to be mounted. Keeping the printing paper sheet stationary on the printing paper supporting surface can be accomplished either by providing a conventional adhesive layer on the printing paper supporting surface so that the printing paper may be peelably secured to the printing paper supporting surface or by providing a conventional positioning structure for the printing paper sheet in the printing paper supporting surface. Such a positioning structure for stencil master plate sheet assemblies, an adhesive layer structure for printing paper, and a positioning structure for printing paper are disclosed, for instance, Japanese utility model publication (kokoku) No. 4-11803, Japanese utility model publication (kokoku) No. 2-272, and Japanese utility model laid open publication (kokai) No. 64-20356, respectively.

In such a stencil printing device, as accessory items, color separated originals for such colors as cyan, magenta and yellow are prepared in advance, and the process of making a stencil master plate for stencil printing from each of the color separated originals is carried out with respect to each individual stencil master plate sheet assembly for each of the color separated originals. Therefore, for each of the stencil master plates to have a same positional relationship with each other, each of the color separated originals must be positioned identically for each of the stencil master plate sheet assemblies when the corresponding stencil master plate is made.

However, according to such a manually operated stencil printing device equipped with the function of making stencil master plates by using flash bulbs, during the process of making stencil master plates, each stencil master plate sheet assembly must be positioned identically as when printing, and each color separated original must be placed identically on the printing paper supporting surface. These positioning steps are extremely difficult and are not practical.

Furthermore, a mis-registration in each step adds up, and the accuracy in registration quickly drops to an unacceptable level. In practice, it was necessary to repeat numerous test prints as a trial and error process until an acceptable registration can be achieved.

### BRIEF SUMMARY OF THE INVENTION

In view of such problems of the prior art, a primary object of the present invention is to provide a method for making stencil master plates, and an original paper sheet for stencil printing, a stencil master plate sheet assembly, and a stencil printing device suitable for use with the method which allow superimposition printing to be carried out highly accurately both in simple and reliable manner without requiring any difficult positioning work.

A second object of the present invention is to provide a method and other related articles which allow a full color stencil printing to be carried out both in accurate and simple manner.

A third object of the present invention is to provide a method and other articles which allow a full color printing to be carried out economically.

These and other objects of the present invention can be accomplished by providing a method for making stencil master plates, comprising the steps of: preparing an original sheet carrying a plurality of original images in a predefined positional relationship; and forming stencil master plates based on the original images in a single stencil master plate sheet assembly in a same positional relationship as the original images in the original sheet.

According to such a method, the stencil master plate for each of the original images can be formed on the stencil master plate sheet assembly at a same relative position as the corresponding original image on the original paper sheet for stencil printing.

Preferably, each of the stencil master plates is formed by thermal perforation involving a photographic exposure with the original sheet and the stencil master plate sheet assembly placed one over the other, and the thermal perforation may be carried out either simultaneously for all of the stencil master plates or individually one stencil master plate at a time. Typically, the original images of the original sheet consist of color separated images which may be combined into a color image by superimposition. If desired, the color separated images may be generated with the aid of a computer, and the color separated images may be formed in stencil master plate sheets by using dot matrices.

The original paper sheet for stencil printing used in this method may comprise a single sheet, and a plurality of original images suitable for printing by superimposition printed in different regions of the single sheet. These original images may be arranged either in a single row on the single sheet, or in angularly displaced locations around a central point.

The stencil master plate sheet assembly used in this method may comprise a frame holder including a plurality of frames each defining an window; a stencil master plate sheet extending over each of the windows; and positioning means for positioning the window of each of the frames to a part of a stencil printing device in a predetermined relationship. So as to be compatible with the original sheet used, the windows are arranged in a single row in the frame holder or in angularly displaced locations around a central point.

For the convenience of mounting each of the stencil master plates on a stencil printing device, the frame holder may be provided with means for separating the frames one from the other.

As a stencil printing device suitable for carrying out the method of the present invention, the present invention further provides a stencil printing device, comprising a base including a printing paper sheet supporting table for supporting a printing paper sheet thereon; a pressure plate carrying a mounting unit, and adapted to press a stencil master plate sheet assembly mounted on the mounting unit onto a printing paper supporting table, the stencil master plate sheet assembly including a plurality of stencil master plates formed therein; and means for supplying printing ink to each of the stencil master plates; the mounting unit being moveable relative to the pressure plate so that each of the stencil master plates formed in the stencil master plate sheet assembly may be sequentially and individually pressed onto the printing paper sheet supported by the printing paper sheet supporting table. Again, so as to be compatible with the particular type of the stencil master plate sheet assembly used on this printing device, the mounting unit may be either moveable in a linear direction with respect to the pressure plate or rotatable with respect to the pressure plate.

Thus, each of the stencil master plates for the different original images can be formed at a same positional relationship in the stencil master plate sheet with respect to the corresponding frame of the stencil master plate sheet assembly.

Preferably, for correcting possible mis-registration between the original sheet and the stencil master plate sheet assembly, the mounting unit is provided with means for adjusting the angular position of the stencil master plate sheet assembly relative to the pressure plate when the mounting unit is moveable in a linear direction with respect to the pressure plate, or with means for adjusting the center of rotation of the stencil master plate sheet assembly relative to the pressure plate when the mounting unit is rotatable with respect to the pressure plate.

### BRIEF DESCRIPTION OF THE DRAWINGS

Now the present invention is described in the following with reference to the appended drawings, in which:
Figure 1 is a perspective view showing an embodiment of the original image paper sheet and the stencil master plate sheet assembly which can be used for carrying out the method of making stencil master plates according to the present invention;
Figure 2 is a perspective view showing an embodiment of the manually operated stencil printing device equipped with the function of making stencil master plates which is suitable for carrying out stencil printing and the method of making stencil master plates according to the present invention;
Figure 3 is a perspective view showing another embodiment of the manually operated stencil printing device according to the present invention;
Figure 4 is a perspective view showing yet another embodiment of the manually operated stencil printing device according to the present invention;
Figure 5 is a diagram illustrating how the orientation of the stencil master plate sheet assembly may be adjusted;
Figure 6 is a perspective view showing another embodiment of the original image paper sheet and the stencil master plate sheet assembly which can be used for carrying out the method of the present invention;
Figure 7 is a perspective view showing yet another embodiment of the stencil printing device of the ink pad type which is suitable for carrying out stencil printing by using stencil master plates prepared by the method of the present invention;
Figure 8 is a side view showing yet another embodiment of the manually operated stencil printing device which is suitable for carrying out stencil printing by using stencil master plates prepared by the method of making stencil master plates according to the present invention;
Figure 9 is a perspective view showing another embodiment of the original image paper sheet and the stencil master plate sheet assembly which can be used for carrying out the method of the present invention;
Figure 10 is a perspective view showing yet another embodiment of the stencil printing device of the ink pad type which is suitable for carrying out stencil printing by using stencil master plates prepared by the method of the present invention;
Figure 11 is a perspective view showing yet another embodiment of the manually operated stencil printing device using a circular stencil master plate sheet assembly according to the present invention; and
Figure 12 is a perspective view showing an embodiment of the manually operated stencil printing device, similar to that of Figure 11, provided with means for adjusting the center of rotation of the circular stencil master plate sheet assembly according to the present invention.

### DETAILED DESCRIPTION OF THE PREFERRED EMBODIMENTS

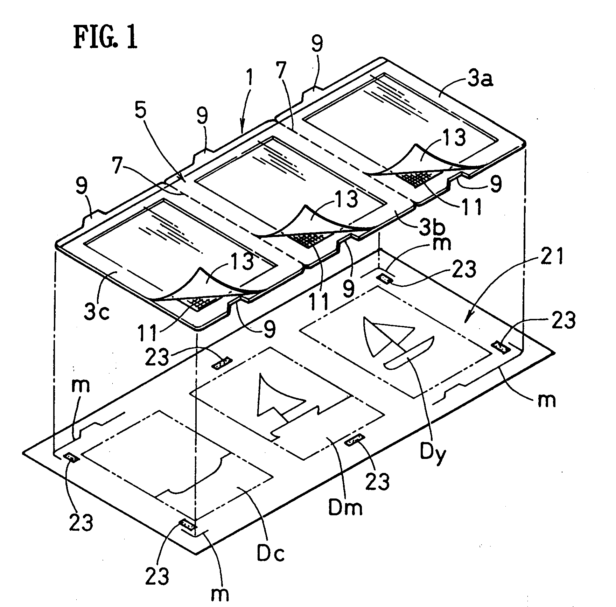

Now the preferred embodiments of the present invention are described in the following with reference to the appended drawings. Figure 1 shows a first embodiment of the original paper sheet and the stencil master plate sheet assembly for carrying out the method of making stencil master plates according to the present invention. In Figure 1, numeral 1 denotes a stencil master plate sheet assembly, and numeral 21 denotes an original paper sheet for stencil printing.

The illustrated stencil master plate sheet assembly 1 comprises a frame holder 5 including a plurality of, three in the present embodiment, frames 3a, 3b and 3c arranged laterally. The frame holder 5 is made of cardboard paper, and can be separated into the individual frames 3a, 3b and 3c with the aid of perforations extending between adjacent ones of the frames. The frame holder 5 is provided with a positioning projection 9 and a positioning notch 9 for each of the frames at an identical relative position.

A stencil master plate sheet 11 made by laminating a thermoplastic film and a fibrous sheet so as to be thermally perforated (for instance, through a photographic exposure or according to data stored in a computer) is fitted on one face of the frame holder 5 for each of the frames 3a, 3b and 3c, and an ink cover sheet 13 consisting of a transparent plastic sheet is placed over the other face of each of the frames 3a, 3b and 3c of the frame holder 5 so as to be opened and closed as desired.

This stencil master plate sheet assembly 1 has a substantially identical structure as the stencil master plate sheet assembly for Print Gokko (tradename of Riso Kagaku Kabushiki Kaisha) with regard to each of the frames 3a, 3b and 3c. For more details of such a stencil master plate sheet assembly, reference should be made to Japanese utility model laid open (kokai) publication No. 51-132007.

The original paper sheet 21 for stencil printing consists of a single sheet of paper, and a plurality of color separated original images Dc, Dm and Dy of such colors as cyan, magenta and yellow for full color printing are printed in different regions of the single paper sheet at a predefined positional relationship. The positional relationship of color separated original images Dc, Dm and Dy is identical to that of the frames 3a, 3b and 3c of the frame holder 5.

Registration marks m are printed on four corners of the original paper sheet 21 for stencil printing as contour lines of the stencil master plate sheet assembly 1 for the convenience of achieving a desired registration between the original paper sheet 21 and the stencil master plate sheet assembly 1 when making stencil master plates.

Part of the surface of the original paper sheet 21 outside the region for the original images is coated with patches of an adhesive layer.

When stencil master plates are to be made by using such a stencil master plate sheet assembly 1 and an original paper sheet 21, by using the registration marks m, the stencil master plate sheet assembly 1 is placed over the surface of the original paper sheet 21 on which the images are printed, with the stencil master plate sheet of the stencil master plate sheet assembly 1 facing down. As a result, the original paper sheet 21 is bonded onto the stencil master plate sheet assembly 1 by virtue of the patches of an adhesive layer 23.

In this bonded condition, the original images Dc, Dm and Dy for stencil printing correspond to the frames 3a, 3b and 3c of the frame holder 5, respectively.

Some vertical and lateral mis-registration between the stencil master plate sheet assembly 1 and the original paper sheet 21 will not cause any mis-registration during the superimposition printing process as long as there is no angular mis-registration between them.

Light is radiated upon the stencil master plate sheet 11 of the stencil master plate sheet assembly 1 from the side of the ink cover sheet 13 of the stencil master plate sheet assembly 1 in such a laminated state, and a stencil master plate is thermally prepared.

The process of plate making may be carried out either simultaneously or sequentially for each of the frames 3a, 3b and 3c of the frame holder 5 or for each of the original images Dc, Dm and Dy of the original paper sheet 21 for stencil printing. If the plate making is to be carried out sequentially for each of the frames 3a, 3b and 3c of the frame holder 5, it is necessary to do so without changing the relative position between the stencil master plate sheet assembly 1 and the original paper sheet 21 for stencil printing. This is ensured when the first stencil master plate is thermally made because the original paper sheet 21 for stencil printing becomes adhered to the stencil master plate 11 as a result, and, in this embodiment, additionally because the original paper sheet 21 for stencil printing adheres to the stencil master plate 11 by virtue of the adhesive layer 23.

When the process of plate making is completed as described above, stencil master plates are formed in the frames 3a, 3b and 3c of the stencil master plate sheet assembly 1 according to the original images Dc, Dm and Dy of the original paper sheet 21 for stencil printing, respectively, in an identical relative positional relationship.

Thus, the stencil master plates for the original images Dc, Dm and Dy of the original paper sheet 21 for stencil printing are formed in the frames 3a, 3b and 3c of the stencil master plate sheet assembly 1, respectively, according to the identical relative positional relationship, and because the positional relationship of the original images Dc, Dm and Dy in the original paper sheet 21 for stencil printing is appropriately set from the beginning, the relative positional relationship of the frames 3a, 3b and 3c is necessarily appropriate.

When a full color printing is to executed through the process of superimposition using the stencil master plates based on the original images Dc, Dm and Dy which are color separated into the colors of cyan, magenta and yellow, because the original images Dc, Dm and Dy are arranged on the original paper sheet 21 for stencil printing so as to be associated with the positioning of the frames 3a, 3b and 3c in the stencil master plate sheet assembly 1, the stencil master plates are made in the stencil master plate sheet assembly 1 in an identical relationship for the frames 3a, 3b and 3c, and a highly accurate full color print free from mis-registration can be obtained, without requiring any special manual registration efforts, simply by carrying out the process of stencil printing by using the stencil master plate sheet 11 for each of the frames 3a, 3b and 3c of the stencil master plate sheet assembly 1.

Once the stencil master plates are formed in the frames 3a, 3b and 3c of the stencil master plate sheet assembly 1 in an identical positional relationship, the frames 3a, 3b and 3c may be separated from each other along the perforations 7, and may be individually mounted on the stencil printing device.

The original paper sheet 21 for stencil printing having the original images Dc, Dm and Dy at a prescribed positional relationship is prepared by the color separation printing process based on the color separation image processing technology.

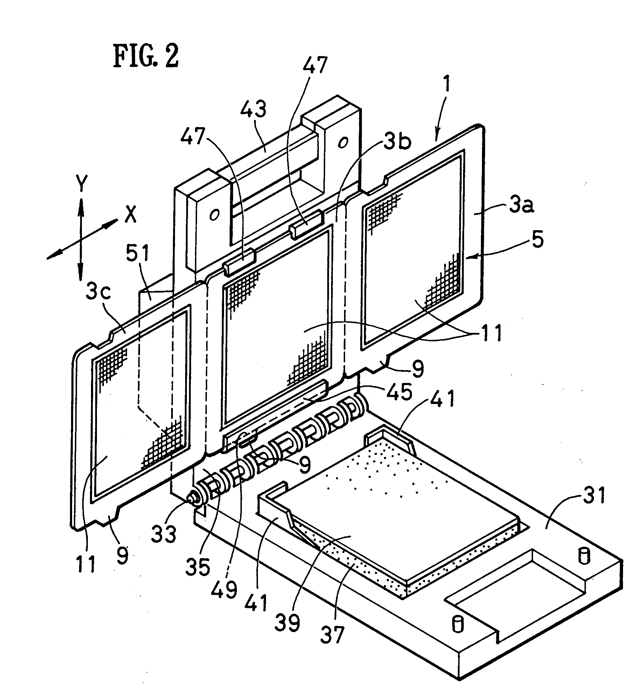

Figure 2 shows an embodiment of the manually operated stencil printing device having the function of plate making which is capable of making printing master plates and carrying out stencil printing. This stencil printing device comprises a base 31, a pressure plate 35 which can rotate substantially vertically by being pivotally mounted to an end of the base 31 via a horizontal pivot shaft 33.

On the base 31 is provided a printing paper supporting table 37 consisting of elastic material such as foamed plastic, and soft foamed polyurethane. The upper surface of the printing paper supporting table 37 is entirely covered by an adhesive layer 39 consisting of silicone rubber, adhesive polyurethane resin or the like so that printing paper may be peelably retained thereon.

Two adjacent corners of the printing paper supporting table 37 are each provided with an L-shaped corner guide 41 for positioning printing paper on the printing paper supporting table 37 in a vertically moveable manner. Each of the corner guides 41 is of a known type which is normally urged upward by a spring not shown in the drawing, and can be depressed under the pressure of the pressure plate 35 during the processes of plate making and printing. For more details of the structure of the corner guides 41, reference should be made to Japanese utility model laid open (kokai) publication No. 64-20356.

The pressure plate 35 is provided with a handle 43 for its handling, and the surface of the pressure plate 35 facing the printing paper supporting surface or the upper surface of the adhesive layer 39 is provided with retaining portions 45 and 47 for a master plate sheet assembly.

The retaining portions 45 and 47 detachably retain the frames 3a, 3b and 3c of the stencil master plate sheet assembly 1, and one of the retaining portions 45 is provided with an opening 49 for receiving the positioning projection 9 of each of the frames 3a, 3b and 3c.

In this case, the positioning of the frames 3a, 3b and 3c of the stencil master plate sheet assembly 1 in the X-direction in Figure 2 is accomplished by the engagement of the master plate sheet retaining portions 45 and 47 without any play, and the positioning in the Y-direction in Figure 2 is accomplished by the engagement of the projections 9 with the positioning opening 49 again without any play. When a higher positioning accuracy is desired, the master plate sheet retaining portions 47 may be incorporated with springs so that the stencil master plate sheet assembly 1 may be pushed against the master plate sheet retaining portion 45.

The pressure plate 35 is provided with a lamp house 51 for thermal plate making in a detachable manner. The lamp house 51 is adapted to replaceably hold flash bulbs so that the plate making of the stencil master plate sheet 11 of the stencil master plate sheet assembly 1 may be thermally carried out by the flash of the flash bulbs, although it is not shown in the drawing.

When the process of plate making according to the present invention is to be carried out by using the stencil printing device having the function of plate making as described above, the stencil master plate sheet assembly 1 is placed over the front surface of the original paper sheet 21 for stencil printing with the stencil master plate sheet facing the original paper sheet 21 by using the registration marks m, and the original paper sheet 21 is thereby secured on the stencil master plate sheet assembly 1 by means of the adhesive layer 23.

In this mutually secured condition, one of the frames 3a, 3b and 3c of the stencil master plate sheet assembly 1 is engaged with the stencil master plate sheet retaining portions 45 and 47 while the positioning projection 9 in the corresponding frame is engaged by the positioning opening 49.

Thus, the stencil master plate sheet assembly 1 is positioned with respect to the pressure plate 35 for each of the frames 3a, 3b and 3c.

After the pressure plate 35 is turned clockwise as seen in Figure 1 around the pivot shaft 33 by holding the handle 43, and the pressure plate 35 is pushed against the printing paper supporting table 77 in this condition, the flash bulbs in the lamp house 51 are flashed. As a result, the stencil master plate sheet 11 of one of the frames 3a, 3b and 3c of the stencil master plate sheet assembly 1 is thermally processed into a stencil master plate for the corresponding one of the original images Dc, Dm and Dy.

Thereafter, each time the plate making process for each of the frames 3a, 3b and 3c of the stencil master plate sheet assembly 1 is completed, the stencil master plate sheet assembly 1 is removed from the pressure plate 35, and another, unprocessed one of the frames 3a, 3b and 3c of the stencil master plate sheet assembly 1 is engaged with the stencil master plate retaining portions 45 and 47 and the positioning projection 9 of the corresponding frame is fitted into the positioning opening 49 so that the plate making process may be repeated on this frame also.

In this manner, the stencil master plate 11 of each of the frames 3a, 3b and 3c of the stencil master plate sheet assembly 1 is thermally processed into a stencil master plate for the corresponding one of the original images Dc, Dm and Dy.

Thus, the stencil master plates based on the original images Dc, Dm and Dy of the original paper sheet 21 for stencil printing are prepared in the frames 3a, 3b and 3c of the stencil master plate sheet assembly 1 in identical positional relationship as the original images Dc, Dm and Dy. Therefore, if the positional relationship of the original images Dc, Dm and Dy of the original paper sheet 21 for stencil printing is appropriate, the positional relationship of the stencil master plates in the frames 3a, 3b and 3c is intrinsically appropriate.

When carrying out the process of stencil printing, a printing paper sheet is placed on the adhesive layer 39 of the printing paper supporting table 37, and is made to stick to the adhesive layer 39 with the printing paper properly positioned with the aid of the corner guides 41.

Inks of various colors such as cyan, magenta and yellow are charged between the ink cover sheets 13 and the stencil master plate sheets 11 of the frames 3a, 3b and 3c of the stencil master plate sheet assembly 1, respectively, and one of the frames for the stencil master plate for the first print, for instance the frame 3a for the original image Dc is engaged by the stencil master sheet retaining portions 45 and 47, and the corresponding projection 9 is fitted into the positioning opening 49 so that the stencil master plate may be properly positioned with respect to the pressure plate 35.

When the pressure plate 35 is turned clockwise as seen in Figure 2 around the pivot shaft 33 by holding the handle 43, and the pressure plate 35 is pushed against the printing paper supporting table 37 in this condition, the stencil master plate sheet 11 in the frame 3a of the stencil master plate sheet assembly 1 is pushed against the printing paper sheet supported on the adhesive layer 39, and the stencil printing for cyan color is carried out.

Upon completion of the step of stencil printing for cyan color, the frame 3b carrying the stencil master plate based on the original image Dm for the second print is engaged by the stencil master sheet retaining portions 45 and 47, and the corresponding projection 9 is fitted into the positioning opening 49 so that the stencil master plate may be properly positioned with respect to the pressure plate 35.

When the pressure plate 35 is turned clockwise as seen in Figure 2 around the pivot shaft 33 by holding the handle 43, and the pressure plate 35 is pushed against the printing paper supporting table 37 in this condition, the stencil master plate sheet 11 in the frame 3b of the stencil master plate sheet assembly 1 is pushed against the printing paper sheet supported on the adhesive layer 39, and the stencil printing for magenta color is carried out.

Upon completion of the step of stencil printing for magenta color, the frame 3c carrying the stencil master plate based on the original image Dy for the third print is engaged by the stencil master sheet retaining portions 45 and 47, and the corresponding projection 9 is fitted into the positioning opening 49 so that the stencil master plate may be properly positioned with respect to the pressure plate 35.

When the pressure plate 35 is turned clockwise as seen in Figure 2 around the pivot shaft 33 by holding the handle 43, and the pressure plate 35 is pushed against the printing paper supporting table 37 in this condition, the stencil master plate sheet 11 in the frame 3c of the stencil master plate sheet assembly 1 is pushed against the printing paper sheet supported on the adhesive layer 39, and the stencil printing for yellow color is carried out.

The printing paper is kept stationary by being secured on the adhesive layer 39 while the printing process for the three colors is completed, and a full color printing is carried out on the printing paper by superimposition of the prints of the three colors.

Thus, the frames 3a, 3b and 3c carrying the stencil master plates are each mounted on an identical position of the pressure plate 35 of the stencil printing device, and the stencil master plates based on the original images Dc, Dm and Dy of the original paper sheet 21 for stencil printing are prepared in the frames 3a, 3b and 3c of the stencil master plate sheet assembly 1 in identical positional relationship as the original images Dc, Dm and Dy. Therefore, the prints are made at high accuracy without involving any mis-registration.

When carrying out the process of stencil printing, the frames 3a, 3b and 3c may be separated from each other along the perforations 7, and individually mounted on the stencil printing device.

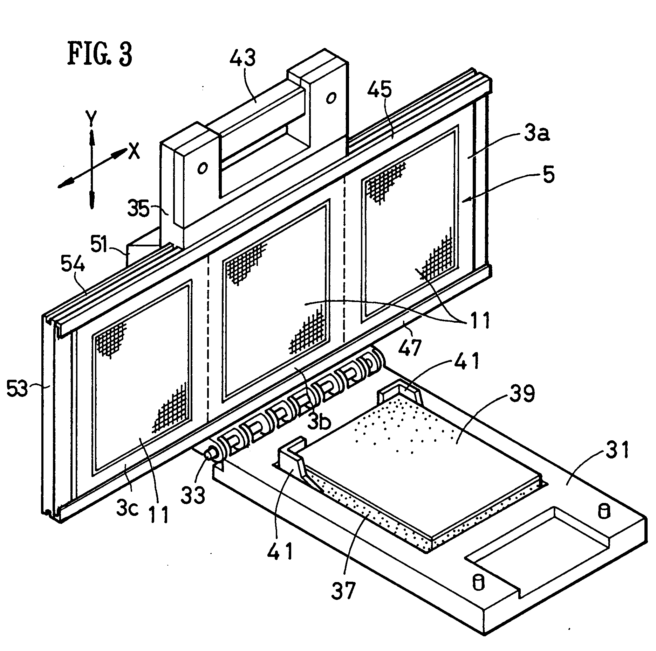

Figure 3 shows another embodiment of the manually operated stencil printing device equipped with the function of making master plates which is suitable for both making master plates and carrying out a stencil printing process. In Figure 3, the parts corresponding to those of Figure 2 are denoted with like numerals.

In this embodiment, a stencil master plate sheet assembly supporting slider 53 is mounted on the pressure plate 35 in a laterally slidable manner (in the X-direction) guided by slide rails 54. The stencil master plate sheet assembly supporting slider 53 is provided with a detent mechanism or the like for moving the stencil master plate sheet assembly 1 to any one of three prescribed positions so that each of the frames 3a, 3b and 3c of the stencil master plate sheet assembly 1 carried thereby may be made to oppose the printing paper supporting table 37 in a selective manner.

In this embodiment, by moving the stencil master plate sheet assembly supporting slider 53 laterally along the slide rails 54, and positioning it at one of the three positions defined by the detent mechanism, a selected one of the frames 3a, 3b and 3c of the stencil master plate sheet assembly 1 can be set for a position for printing, and the stencil printing using the stencil master plate of each selected one of the frame 3a, 3b or 3c of the stencil master plate sheet assembly 1 can be carried out in the same way as in the previous embodiment.

In this case, the stencil master plate sheet assembly 1 is not required to be provided with a notch 9 for each of the frames 3a, 3b and 3c.

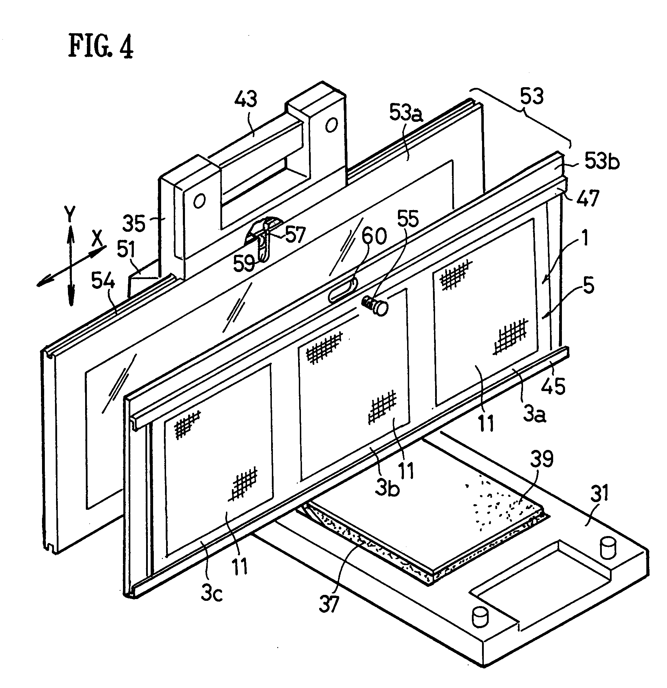

Figure 4 shows an embodiment of the stencil printing device which is provided with means for adjusting the angular position of the stencil master plate sheet assembly 1. In this stencil printing device, the stencil master plate sheet assembly supporting slider 53 comprises a slider main body 53a which is laterally slidably engaged with the pressure plate 35, and an assembly supporting member 53b which supports the stencil master plate sheet assembly 1 via the stencil master plate sheet retaining portions 45 and 47 and can be fixedly secured to the slider main body 53a at an arbitrary angular orientation by means of a setting screw 55.

In this embodiment, the set screw 55 threads with a nut 57 which is in turn vertically (in the Y-direction) moveably engaged with the slider main body 53a, and a through hole 59 provided in the slider main body 53a for receiving the set screw 55 is formed as a slot extending in the vertical direction (in the Y-direction) while another through hole 60 provided in the assembly supporting member 53b for receiving the set screw 55 is formed as a slot extending in the lateral direction (in the X-direction). Thus, the assembly supporting member 53b can be fixedly secured to the slider main body 53a at a desired angular orientation, and can be finely adjusted both vertically and laterally with respect to the slider main body 53a.

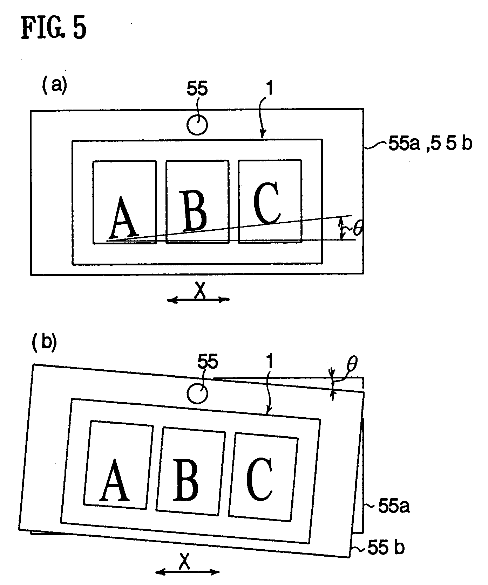

By the provision of such an adjustment mechanism, even when the stencil master plates A, B and C for the original images Dc, Dm and Dy are formed in the stencil master plate sheets 11 of the stencil master plate sheet assembly 1 obliquely by the angle of ϑ with respect to the direction (X-direction) of the movement of the stencil master plate sheet assembly supporting slider 53 relative to the pressure plate 35 as illustrated in Figure 5(a), the resulting mis-registration of the printed images can be corrected by rotating the assembly supporting member 53b relative to the slider main body 53a around the set screw 55, and securing it at this position so that the stencil master plates A, B and C may be aligned in parallel with the direction of the movement of the stencil master plate sheet assembly supporting slider 53 relative to the pressure plate 35.

The adjustment mechanism for adjusting the angular position of the assembly supporting member 53b is not limited by the above described embodiment, but may be achieved in a number of different ways. For instance, the assembly supporting member 53b may be supported by the slider main body 53a in a floating relationship so that the assembly supporting member 53b may move laterally, vertically and angularly, and be fixedly secured at a desired position. Alternatively, magnets may be employed so that the assembly supporting member 53b may be secured to the slider main body 53a at a desired position and at a desired orientation.

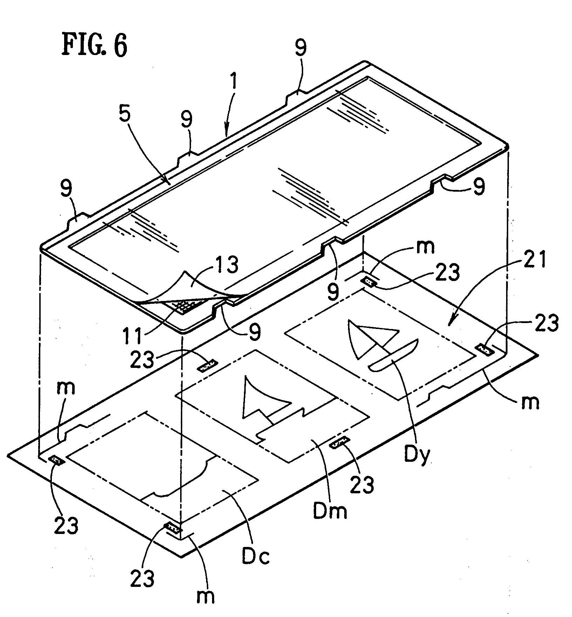

In the above described embodiments, the frame holder 5 of the stencil master plate sheet assembly 1 can be separated into each of the frames 3a, 3b and 3c. But, if it is not necessary, the frame holder 5 may not be provided with individual frames 3a, 3b and 3c as illustrated in Figure 6..

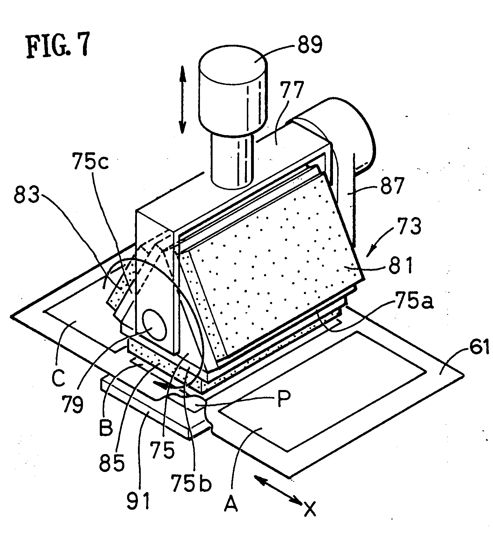

Figure 7 shows an embodiment of the stencil printing device which is suitable for carrying out the process of stencil printing by using a stencil master plate prepared according to the plate making method described above.

In this embodiment, stencil master plates A, B and C are formed in three different locations of a single stencil master plate sheet assembly 61 by using an original paper sheet 21 for stencil printing according to the method of making master plates described above.

Above the stencil master plate sheet assembly 61 is provided an ink pad device 73. This ink pad device 73 comprises a pad mount member 75 provided with the shape of a rod having a triangular cross section, and the pad mount member 75 is rotatably supported by a bracket member 77 via a pivot shaft 79. The pad mount member 75 is provided with ink pads 81, 83 and 85 each consisting of an ink impregnated layer on its three sides 75a, 75b and 75c, respectively. The ink pads 81, 83 and 85 are impregnated with yellow, magenta and cyan printing inks, respectively.

The pad mount member 75 can rotate around the pivot shaft 79 by 120 degrees at a time by an index drive device 87 incorporated with an electric motor so that a selected one of the ink pads 81, 83 and 85 may face the upper surface of the stencil master plate sheet assembly 61.

The bracket member 77 is supported by a vertical actuator 89 so as to be vertically moveable between an upper position moved upward away from the upper surface of the stencil master plate sheet assembly 61 and a lower position for pressing one of the ink pads 81, 83 and 85 onto the upper surface of the stencil master plate sheet assembly 61.

Below the stencil master plate sheet assembly 61 is provided a printing paper supporting table 91 in a fixed relationship opposite to the ink pad device 73 interposing the stencil master plate sheet assembly 61 therebetween, and the printing paper supporting table 91 can support a printing paper sheet P in a replaceable manner at a position slightly spaced from the lower surface of the stencil master plate sheet assembly 61.

In this embodiment, a printing paper sheet P is placed on the printing paper sheet supporting table 91, and the stencil master plate sheet assembly 61 having stencil master plates A, B and C made therein is selectively moved in the aligning direction of the stencil master plates or in the direction indicated by the arrow X in the drawing so that each one of the stencil master plates A, B and C may be placed right under the ink pad device 73 at a time. By indexing the pad mount member 75 by 120 degrees around the pivot shaft 79 by using the indexing drive device 87 with the bracket member 77 placed at its upper position, each one of the ink pads 81, 83 and 85 is made to oppose the upper surface of the stencil master plate sheet assembly 61. The bracket member 77 is lowered by the vertical actuator 89 in this condition, and the ink pad 81, 83 or 85 opposing the upper surface of the stencil master plate sheet assembly 61 is pushed onto the upper surface of the stencil master plate sheet assembly 61. As a result, the stencil master plate sheet assembly 61 is brought into engagement with the printing paper sheet P on the printing paper sheet supporting table 91, and the printing ink impregnated in the corresponding ink pad 81, 83 or 85 is transferred onto the printing paper sheet P on the printing paper sheet supporting table 91 so that the desired stencil master plates may be made by using the stencil master plates A, B or C.

In this case also, because the stencil master plates A, B and C are formed in the stencil master plate sheet of the stencil master plate sheet assembly 61 in such a positional relationship that they are identically positioned as the original images in the single original paper sheet 21 for stencil printing, the relative positioning of the master plates A, B and C is ensured to be appropriate without any deliberate effort. By shifting the stencil master plate sheet assembly 61 in the direction of the arrow each time by the amount corresponding to the pitch of the stencil master plates A, B and C in the master plate sheet assembly 61, and by accordingly changing the ink pad to be used each time through the indexing of the pad mount member 75 by 120 degrees, the process of superimposition printing can be accomplished on the printing paper sheet P supported by the printing paper supporting table 91 by using printing inks of various colors.

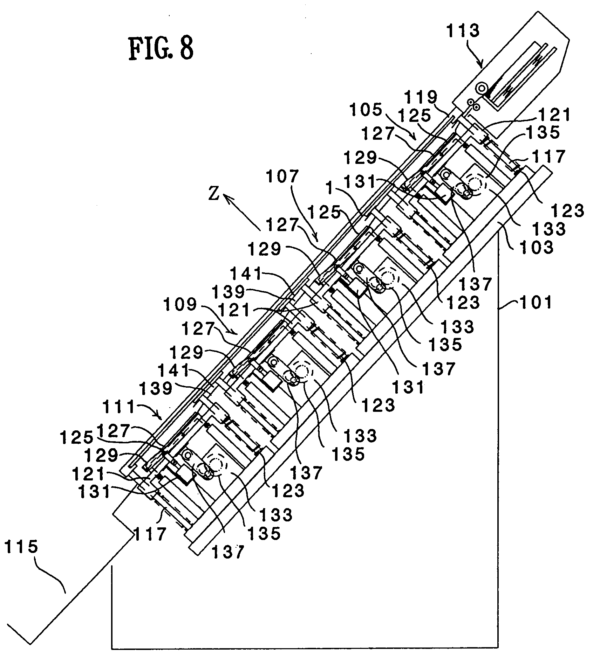

Figure 8 shows yet another embodiment of the stencil printing device which is suitable for carrying out the process of stencil printing by using a stencil master plate prepared according to the plate making method described above.

In this embodiment, an inclined base 103 is supported by a base frame 101, and four printing assemblies 105, 107, 109 and 111 are arranged in a single row along an inclined plane on the base 103. An automatic paper feeding device 113 is provided upstream of the uppermost printing assembly 105, and a paper ejection table 115 is provided downstream of the lowermost printing assembly 111.

Each of the printing assemblies 105, 107, 109 and 111 is provided with guide posts 117 extending perpendicularly to the included upper surface of the base 103, and the free ends or the upper ends of the guide posts 117 support a stencil master plate sheet supporting portion 119 extending in parallel with the inclined upper surface of the base 103. The stencil master plate sheet supporting portion 119 is common to all of the printing assemblies 105, 107, 109 and 111, and a stencil master plate sheet assembly 1 as illustrated in Figures 1 through 4 can be mounted on it in a continuous manner. In this case, one stencil master plate is individually made in the stencil master plate sheet assembly 1 for each of the printing assemblies 105, 107, 109 and 111, or four stencil master plates in all are made in the stencil master plate sheet assembly 1.

A moveable table 121 is engaged with the guide posts 117 for each of the printing assemblies 105, 107, 109 and 111 in axially slidable manner as a translational movement, and is normally urged upward or in the direction indicated by the arrow Z in the drawing (hereinafter, this direction is simply called as "upward", and the direction opposite to it simply as "downward") by compression coil springs 123.

Each of the moveable tables 121 carries a printing paper sheet supporting table 125 fixedly secured thereto. The upper surface of the printing paper sheet supporting table 125 is defined as a printing paper sheet supporting surface 127 which also inclines and extends in parallel with the inclined upper surface of the base 103. In other words, the printing paper sheet supporting surfaces 127 oppose the surfaces of the stencil master plates of the stencil master plate sheet assembly 1 supported by the stencil master plate sheet supporting portion 119 in mutually parallel relationship.

The printing paper sheet supporting table 125 of each of the printing assemblies 105, 107, 109 and 111 is provided with a gate member 129 which can rotate vertically. Each of the gate members 129 is provided with the shape of a staple, and can rotatively move by being actuated by a solenoid device 131 between a closed position for preventing the fall of the printing paper sheet along the printing paper sheet supporting table 125 and a closed position for allowing the fall of the printing paper sheet along it.

Each of the printing assemblies 105, 107, 109 and 111 is provided with a vertical drive assembly 133 for actuating the corresponding moveable table 121. Each of the vertical drive assemblies 133 is incorporated with an electric motor 135, and is drivingly coupled with the moveable table 121 via a link member 137.

Thus, the moveable table 121 of each of the printing assemblies 105, 107, 109 and 111 can be moved by the electric motor 135, guided by the guide posts 117, between a lower position for moving the printing paper sheet supporting surface 127 of the printing paper sheet supporting table 125 downward away from the stencil master plate sheet supporting portion 119, and an upper position for pressing the printing paper sheet supporting surface 127 onto the surface of the stencil master plate of the stencil master plate sheet assembly 1 supported by the stencil master plate sheet supporting portion 119.

Between each pair of the printing paper sheet supporting tables 125 next to each other, a flexible guide member 139 made of such material as mylar film is connected to the gate member 129 of the upstream printing paper sheet supporting table 125 at its one end and to the upper end of the inclined surface of the downstream printing paper sheet supporting table 125 at its other end for the purpose of guiding the downward movement of each printing paper sheet from one printing paper sheet supporting table 125 to another. Another flexible guide member 141 is provided above each of the flexible guide members 139.

In this stencil printing device, by virtue of the vertical movement of each of the moveable tables 121, and the opening and closing action of each of the gate members 129 by the solenoid device 131, each printing paper sheet is supplied to the printing assemblies 105, 107, 109, and 111 in a sequential manner under the action of the gravity, and the printing paper sheet is positioned by each of the gate members 129 for making a print based on the principle of superimposition at each of the printing assemblies 105, 107, 109 and 111.

As a result, by using yellow, magenta, cyan and black printing inks in the printing assemblies 105, 107, 109 and 111, respectively, a full color printing can be accomplished.

If necessary, reference should be made to the specification and drawings of Japanese patent application No. 4-142306 filed by the same applicant for more details of this stencil printing device.

In each of the above described embodiments, the original images are arranged in a single row in a single original image paper sheet for stencil printing, and the configuration of the stencil master plate sheet was determined accordingly. However, the original images may be arranged in two ore more rows in the single original image paper sheet for stencil printing.

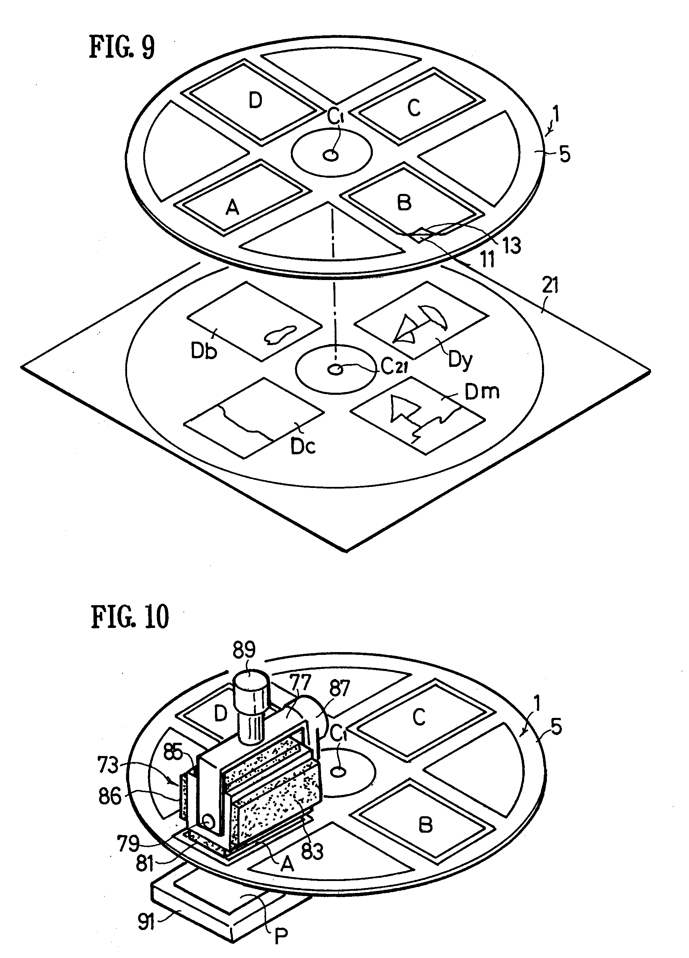

Alternatively, the original images Dc, Dm, Dy and Db in the original image paper sheet 21 may be arranged around a central point C21 as illustrated in Figure 9. The stencil master plate sheet assembly 1 in this case comprises a disk shaped holder 5 in which windows W defining the regions for stencil master plates A, B, C and D are arranged around a central point C1 in the same way as the original images Dc, Dm, Dy and Db are arranged around the central point C21 in the original image paper sheet 21.

In this case, if master plates A, B, C and D are made in the stencil master plate sheet assembly 1 with the central point C21 of the original image paper sheet 21 exactly aligned with the central point C1 of the stencil master plate sheet assembly 1, the positional relationship of the master plates A, B, C and D are kept identical to that of the original images Dc, Dm, Dy and Db in the stencil master plate sheet assembly 1.

Figure 10 shows another embodiment of the stencil printing device of the ink pad type which is adapted to use the circular stencil master plate sheet assembly 1 illustrated in Figure 9. In Figure 10, the parts corresponding to those of Figure 7 are denoted with like numerals. In this stencil printing device, the circular stencil master plate sheet assembly 1 is mounted on a indexing support mechanism not shown in the drawing so as to be rotatable around its center of rotation C1.

This ink pad device 73 comprises a pad mount member 75 provided with the shape of a rod having a square cross section, and the pad mount member 75 is rotatably supported by a bracket member 77 via a pivot shaft 79. The pad mount member 75 is provided with ink pads 81, 83, 85 and 86 each consisting of an ink impregnated layer on its four sides 75a, 75b, 75c and 75d, respectively. The ink pads 81, 83, 85 and 86 are impregnated with yellow, magenta, cyan and black printing inks, respectively.

The pad mount member 75 can rotate around the pivot shaft 79 by 120 degrees at a time by an index drive device 87 incorporated with an electric motor so that a selected one of the ink pads 81, 83, 85 and 86 may face the upper surface of the corresponding region of the stencil master plate sheet assembly 1.

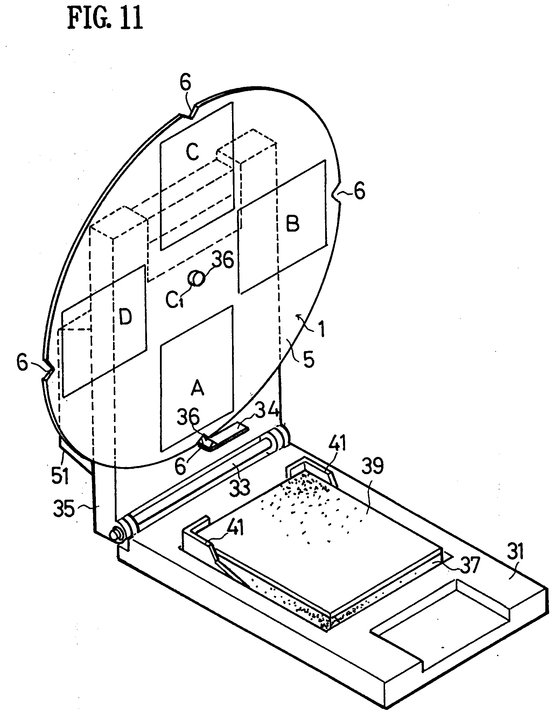

Figure 11 shows an example of the hand operated stencil printing device using the circular stencil master plate sheet assembly 1 illustrated in Figure 9. In this embodiment, the pressure plate 35 is provided with a pivot shaft 36 which rotatably supports the stencil master plate sheet assembly 1 at its central point C1.

This circular stencil master plate sheet assembly 1 is provided with four V-shaped notches 6 at equal interval along the outer periphery of the frame holder 5, and the pressure plate 35 is provided with an engagement claw 38 urged against the outer periphery of the frame holder 5 by a sheet spring 36 so as to serve as a detent mechanism by cooperating with the V-shaped notches 6. According to this embodiment, by rotating the circular stencil master plate sheet assembly 1 until the engagement claw 38 engages with one of the V-shaped notches 6, one of the stencil master plates A, B, C and D is accurately positioned so as to oppose the printing paper sheet supporting table 37. Then, the printing process based on the principle of superimposition can be accomplished substantially in the same way as described in connection with the preceding embodiments.

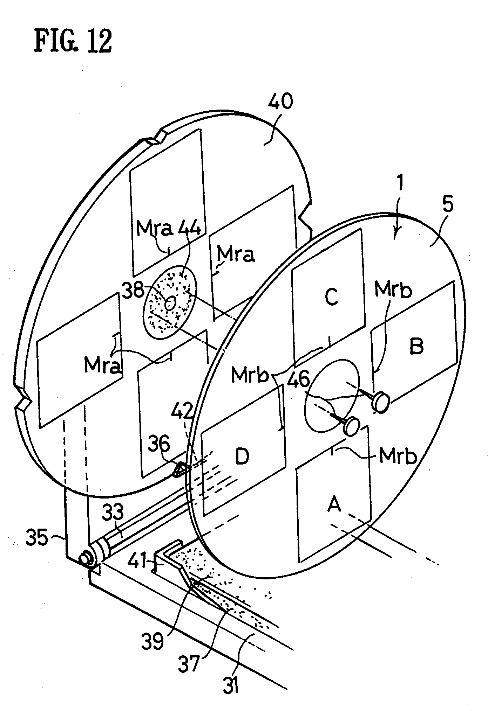

Figure 12 shows yet another embodiment of the manually operated stencil printing device using a stencil master plate sheet assembly illustrated in Figure 7. In this embodiment, a rotating disk 40 is rotatively mounted on the pressure plate 35 via a pivot shaft 38 for supporting the stencil master plate sheet assembly 1.

The outer periphery of the rotating disk 40 is provided with four V-shaped notches 42 at equal interval along the outer periphery of the rotating disk 40, and the pressure plate 35 is provided with an engagement claw 38 urged against the outer periphery of the rotating disk 40 by a sheet spring 36 so as to serve as a detent mechanism by cooperating with the V-shaped notches 42. Thus, the rotating disk 40 can be rotated by 90 degrees at a time. The central part of the rotating disk 40 is provided with a retaining board 44 made of such materials as cork so that the stencil master plate sheet assembly 1 may be secured to the rotating disk 40 with pushpins 46.

According to this embodiment, at least two pushpins 46 are passed through the stencil master plate sheet assembly 1, and pierced into the retaining board 44 to secure the stencil master plate sheet assembly 1 to the rotating disk 40. Thus, the stencil master plate sheet assembly 1 can be also rotated by 90 degrees at a time.

Registration marks Mrb are printed on the rotating disk 40 as an aid for mounting the stencil master plate sheet assembly 1 coaxially to the rotating disk 40. Registration marks Mra are included in the images for the stencil master plates A, B, C and D, and the proper registration of the images of the stencil master plates A, B, C and D is ensured by mounting the stencil master plate sheet assembly 1 on the rotating disk 40 so that the registration marks Mra and Mrb may coincide with one another, even when there is some offset between the central point C21 of the original paper sheet 21 and the central point C1 of the stencil master plate sheet assembly 1.

As can be understood from the above description, according to the method of making stencil master plates of the present invention, by using an original paper sheet for stencil printing having a plurality of original images printed in different regions thereof at a predefined relationship, stencil master plates based on these original images are made in a stencil master plate sheet assembly without changing the positional relationship between the original paper sheet and the stencil master plate sheet. Thus, the stencil master plates are formed in the stencil master plate sheet assembly at the same positional relationship as the corresponding original images in the original image paper sheet, and the stencil master plates may be made in such a manner that the same positional relationship may be achieved for each stencil master plate with respect to the corresponding frame. Therefore, no difficult positioning work is required either when making stencil master plates or when printing, and a printing process based on the principle of superimposition can be accomplished in a simple manner yet with a high level of accuracy.

Although the present invention has been described in terms of preferred embodiments thereof, it is obvious to a person skilled in the art that various alterations and modifications are possible without departing from the scope of the present invention which is set forth in the appended claims.

## Claims

1. A method for making stencil master plates, comprising the steps of:
preparing an original sheet carrying a plurality of original images in a predefined positional relationship; and
forming stencil master plates based on said original images in a single stencil master plate sheet assembly in a same positional relationship as said original images in said original sheet.

2. A method according to claim 1, wherein each of said stencil master plates is formed by thermal perforation involving a photographic exposure with said original sheet and said stencil master plate sheet assembly placed one over the other, and said thermal perforation is carried out simultaneously for all of said stencil master plates.

3. A method according to claim 1, wherein each of said stencil master plates is formed by thermal perforation involving a photographic exposure with said original sheet and said stencil master plate sheet assembly placed one over the other, and said thermal perforation is carried out individually one stencil master plate at a time.

4. A method according to claim 1, wherein said original images of said original sheet consist of color separated images which may be combined into a color image by superimposition.

5. An original paper sheet for stencil printing suitable for use with the method of claim 1, comprising a single sheet, and a plurality of original images suitable for printing by superimposition printed in different regions of said single sheet.

6. An original paper sheet according to claim 5, wherein said original images of said original sheet consist of color separated images which may be combined into a color image by superimposition.

7. An original paper sheet according to claim 5, wherein said original images are arranged in a single row on said single sheet.

8. An original paper sheet according to claim 5, wherein said original images are arranged in angularly displaced locations around a central point.

9. A stencil master plate sheet assembly suitable for use with the method of claim 1, comprising:
a frame holder including a plurality of frames each defining an window;
a stencil master plate sheet extending over each of said windows; and
positioning means for positioning said window of each of said frames to a part of a stencil printing device in a predetermined relationship.

10. A stencil master plate sheet assembly according to claim 9, wherein said windows are arranged in a single row in said frame holder.

11. A stencil master plate sheet assembly according to claim 9, wherein said windows are arranged in angularly displaced locations around a central point.

12. A stencil master plate sheet assembly according to claim 9, wherein said frame holder is provided with means for separating said frames one from the other.

13. A stencil printing device, comprising
a base including a printing paper sheet supporting table for supporting a printing paper sheet thereon;
a pressure plate carrying a mounting unit, and adapted to press a stencil master plate sheet assembly mounted on said mounting unit onto a printing paper supporting table, said stencil master plate sheet assembly including a plurality of stencil master plates formed therein; and
means for supplying printing ink to each of said stencil master plates;
said mounting unit being moveable relative to said pressure plate so that each of said stencil master plates formed in said stencil master plate sheet assembly may be sequentially and individually pressed onto said printing paper sheet supported by said printing paper sheet supporting table.

14. A stencil printing device according to claim 13, wherein said mounting unit is moveable in a linear direction with respect to said pressure plate.

15. A stencil printing device according to claim 14, wherein said mounting unit is provided with means for adjusting the position of said stencil master plate sheet assembly relative to said pressure plate.

16. A stencil printing device according to claim 13, wherein said mounting unit is rotatable with respect to said pressure plate.

17. A stencil printing device according to claim 16, wherein said mounting unit is provided with means for adjusting the center of rotation of said stencil master plate sheet assembly relative to said pressure plate.
